# EUROPEAN PATENT APPLICATION

(11) **EP 3 828 919 A1**
(43) Date of publication of application: **02.06.2021**
(21) Application number: 19929185.7
(22) Date of filing: 30.09.2019
(51) Int. Cl.: H01L 21/56

(54) **PACKAGING STRUCTURE AND FORMING METHOD THEREFOR, AND PACKAGING METHOD**

(71) Applicant: Shenzhen Goodix Technology Co., Ltd., Shenzhen, Guangdong 518045 (CN)
(72) Inventor: WANG, Chaohong, Shenzhen, Guangdong 518045 (CN); YANG, Ke, Shenzhen, Guangdong 518045 (CN); LENG, Hanjian, Shenzhen, Guangdong 518045 (CN)
(74) Representative: Vinsome, Rex Martin
(86) International application number: PCT/CN2019/109543
(87) International publication number: WO 2021/062674

(57) **Abstract**

Some embodiments of the present disclosure provide a packaging structure, a forming method for a packaging structure and a packaging method for a packaging structure. The packaging structure includes a first semiconductor unit (201) and a second semiconductor unit (203). The first semiconductor unit (201) includes a wafer or a chip, the first semiconductor unit (201) has a first surface (21) on which at least one first conductive bump (202) is provided. The second semiconductor unit (203) is fixed on the first surface (21) and includes a wafer or a chip. The second semiconductor unit (203) has a second surface (22) on which at least one second conductive bump (204) is provided. The second surface (22) and the first surface (21) face to each other. The second conductive bump (204) and the first conductive bump are oppositely arranged and fixed to each other.

## Description

### TECHNICAL FIELD

The present disclosure relates to the field of semiconductor technology, in particular to a packaging structure, a forming method for the packaging structure and a packaging method for the packaging structure.

### BACKGROUND

In the existing packaging technology, ball grid array (BGA) packaging, chip scale packaging (CSP), wafer level packaging (WLP), three-dimensional (3D) packaging and system packaging (SiP) are mainly employed. With the continuous development of design and manufacturing level of the integrated circuit, packaging technology usually needs to meet the requirements of high density, high performance, high integration and low cost simultaneously.

The inventor finds that there are at least the following problems in the existing technology. When a packaging process involves two chips, usually a wire bonding packaging method is used to electrically connect the two chips to the same carrier, thereby electrical connection between the two chips is realized through the carrier. The long electrical connection path between the two chips usually results in problems such as signal loss, signal delay, and large power consumption by the chips, and a large overall size of the packaging structure.

### SUMMARY

The objective of some embodiments of the present disclosure is to provide a packaging structure, a forming method for the packaging structure and a packaging method for the packaging structure, which improve electrical performance of the packaging structure and reduces a size of the packaging structure, so as to achieve cost reduction and performance improvement of the packaging structure.

Embodiments of the present disclosure provide a packaging structure including a first semiconductor unit and a second semiconductor unit. Herein, the first semiconductor unit includes a wafer or a chip. The first semiconductor unit has a first surface on which at least one first conductive bump is provided. The second semiconductor unit is fixed on the first surface and includes a wafer or a chip. The second semiconductor unit has a second surface on which at least one second conductive bump is provided. The second surface and the first surface face to each other. The second conductive bump and the first conductive bump are oppositely arranged and fixed to each other. The second semiconductor unit and the first semiconductor unit are electrically connected through the second conductive bump and the first conductive bump.

Embodiments of the present disclosure further provide a forming method for a packaging structure, including: providing a first semiconductor unit, where the first semiconductor unit includes a chip or a wafer, the first semiconductor unit has a first surface on which at least one first conductive bump is provided; providing a second semiconductor unit, where the second semiconductor unit includes a chip or a wafer, the second semiconductor unit has a second surface on which at least one second conductive bump is provided; and connecting fixedly a top surface of the second conductive bump to a top surface of the first conductive bump, where the second surface and the first surface face to each other.

Embodiments of the present disclosure further provide a packaging method, including: providing a semiconductor unit having a first surface, where the semiconductor unit includes a chip or a wafer, the semiconductor unit includes a first region and a second region, a first conductive bump is provided on the first surface in the first region, a second conductive bump is provided on the first surface in the second region, the first region has a first electro-static discharge circuit connected with the first conductive bump, the second region has a second electro-static discharge circuit connected with the second conductive bump, and a preset electro-static discharge voltage value in the first electro-static discharge circuit is greater than a preset electro-static discharge voltage value in the second electro-static discharge circuit; providing a carrier having a second surface, where a first connector and a second connector are provided on the second surface; and performing a flipping and fixing process to fixedly connect a top surface of the first conductive bump to a top surface of the first connector, and to fixedly connect a top surface of the second conductive bump to a top surface of the second connector, where during the flipping and fixing process, a contact between the top surface of the first conductive bump and the top surface of the first connector occurs earlier than a contact between the top surface of the second conductive bump and the top surface of the second connector.

Compared with existing technologies, embodiments of the present disclosure provide a new packaging structure, in which a first semiconductor unit and a second semiconductor unit are flipped and packaged. Electrical connection between the first semiconductor unit and the second semiconductor unit is realized through a fixed connection between a first conductive bump and a second conductive bump, which effectively shortens an electrical connection path between two semiconductor units, and is advantageous for lowering impedance and power consumption, improving heat dissipation and increasing a signal transmission speed, and thus improving electrical performance of the chip. In addition, it is advantageous for reducing a size of a packaging structure and reducing cost of the chip. The packaging structure in the embodiments of the present disclosure may be applied to chip-chip flipping, chip-wafer flipping or wafer-wafer flipping.

For example, the first conductive bump includes a first conductive pillar and a first soldered bump that are stacked in order, the second conductive bump includes a second conductive pillar and a second soldered bump that are stacked in order, and the second soldered bump and the first soldered bump are integrated into one structure.

For example, the first conductive bump further includes a first conductive bonding layer located between the first conductive pillar and the first soldered bump, and the second conductive bump further includes a second conductive bonding layer located between the second conductive pillar and the second soldered bump.

For example, the first semiconductor unit includes a first region and a second region, the first semiconductor unit accommodates a first electro-static discharge circuit electrically connected with the first conductive bump, and a preset electro-static discharge voltage value of the first electro-static discharge circuit in the first region is greater than a preset electro-static discharge voltage value of the first electro-static discharge circuit in the second region.

For example, the packaging structure further includes a carrier, the carrier has a third surface on which the first semiconductor unit is fixed, and the first semiconductor unit is electrically connected with the carrier.

For example, the first semiconductor unit accommodates at least one first soldered pad, a surface of the first soldered pad is exposed from the first surface, the carrier accommodates at least one second soldered pad, a surface of the second soldered pad is exposed from the third surface, and the packaging structure further includes an electrically-connecting structure electrically connecting the second soldered pad and the first soldered pad.

For example, the electrically-connecting structure is a metal wire having one end electrically connected with the first soldered pad and one other end electrically connected with the second soldered pad.

For example, the packaging structure further includes: an adhesive layer located between the first semiconductor unit and the carrier and configured to fix the first semiconductor unit to the carrier.

For example, the electrically-connecting structure comprises a through silicon via located within the first semiconductor unit and having one end connected with the first soldered pad, and a third conductive bump electrically connecting the through silicon via and the second soldered pad.

For example, the first semiconductor unit is a micro-processing control chip or a micro-processing control wafer, and the second semiconductor unit is a storage chip or a storage wafer. In this way, the packaging structure may complete operations such as acquiring an instruction, executing an instruction, and exchanging information with an external memory and logic component via the parallel input and output interfaces. In addition, the packaging structure may achieve embedded flash performance, and thus may replace an embedded flash wafer, thereby avoiding a problem of high cost caused by a manufacturing process of the embedded flash wafer. Besides, in regard to storage requirements of different capacities, such packaging structure solution may be more flexible and standardized.

For example, the first semiconductor unit includes a first region and a second region, the first semiconductor unit accommodates a first electro-static discharge circuit electrically connected with the first conductive bump, and a preset electro-static discharge voltage value of the first electro-static discharge circuit in the first region is greater than a preset electro-static discharge voltage value of the first electro-static discharge circuit in the second region; and during the connecting fixedly a top surface of the second conductive bump to a top surface of the first conductive bump, a contact between the top surface of the first conductive bump and the top surface of the second conductive bump in the first region occurs earlier than a contact between the top surface of the first conductive bump and the top surface of the second conductive bump in the second region. In this way, a contact between the top surface of the first conductive bump and the top surface of the second conductive bump in the first region instantaneously generates a discharge mode. In the discharge mode , static electricity generated instantaneously from the contact between the first semiconductor unit and the second semiconductor unit may be discharged, thereby reducing dependence of the first semiconductor unit or the second semiconductor unit on the electro-static discharge circuit, which is advantageous for reducing complexity of or space arranged for the electro-static discharge circuit, and further, is advantageous for reducing a size of the chip and further improving performance of the chip in the packaging structure.

For example, before fixedly connecting the second conductive bump to the first conductive bump, a sum of a maximum thickness of the first conductive bump and a maximum thickness of a corresponding second conductive bump in the first region is a first thickness, a sum of a maximum thickness of the first conductive bump and a maximum thickness of a corresponding second conductive bump in the second region is a second thickness, and the first thickness is greater than the second thickness.

For example, the top surface of the second conductive bump and the top surface of the first conductive bump are connected fixedly using an ultrasonic soldering processing or a reflow soldering processing.

For example, before the connecting fixedly a top surface of the second conductive bump to a top surface of the first conductive bump, the forming method further includes: providing a carrier having a third surface on which the first semiconductor unit is fixed.

For example, before the flipping and fixing process, a sum of a maximum thickness of the first conductive bump and a maximum thickness of the first connector is a first thickness, a sum of a maximum thickness of the second conductive bump and a maximum thickness of the second connector is a second thickness, and the first thickness is greater than the second thickness.

### BRIEF DESCRIPTION OF THE DRAWINGS

One or more embodiments are described as examples with reference to the corresponding figures in the accompanying drawings, and the examples do not constitute a limitation to the embodiments. The figures in the accompanying drawings do not constitute a limitation to proportion unless otherwise stated. The following setting of embodiments is to facilitate description, but should not constitute any definition to the particular implementation of the present disclosure. Without contradiction, the embodiments may be referred to or combined with each other.
FIG. 1 is a schematic sectional view of a packaging structure provided in a first embodiment of the present disclosure;
FIG. 2 is a schematic sectional view of a packaging structure provided in a second embodiment of the present disclosure;
FIG. 3 is a schematic sectional view of another packaging structure provided in the second embodiment of the present disclosure;
FIG. 4 is a schematic top view of a second semiconductor unit in the second embodiment;
FIGs. 5 to 7 are schematic views of structures corresponding to respective steps of a forming method for a packaging structure provided in a third embodiment of the present disclosure;
FIGs. 8 to 11 are schematic views of structures corresponding to respective steps of a forming method for a packaging structure provided in a fourth embodiment of the present disclosure;
FIGs. 12 to 16 are schematic views of sectional structures corresponding to respective steps for a packaging method provided in a fifth embodiment of the present disclosure.

### DETAILED DESCRIPTION

In order to make the objective, the technical solution and advantages of the present disclosure clearer, some embodiments of the present disclosure will be described in further details with reference to the drawings and examples. It shall be appreciated that the specific embodiments described herein are for explaining rather than defining the present disclosure.

Some embodiments of the present disclosure relate to a packaging structure, and a first semiconductor unit and a second semiconductor unit are flipped and packaged. That is, a first conductive bump on a first surface of the first semiconductor unit fixedly contacts a second conductive bump on a second surface of the second semiconductor unit, with the first surface and the second surface facing each other. The first semiconductor unit includes a die/chip or a wafer, and the second semiconductor unit includes a die/chip or a wafer. In this way, an electrical connection path between the first semiconductor unit and the second semiconductor unit is effectively shortened, thereby an electrical connection impedance is lowered, power consumption of the first semiconductor unit or the second semiconductor unit is reduced, and their electrical performance is effectively improved. Meanwhile, this is advantageous for reducing a size and cost of the packaging structure.

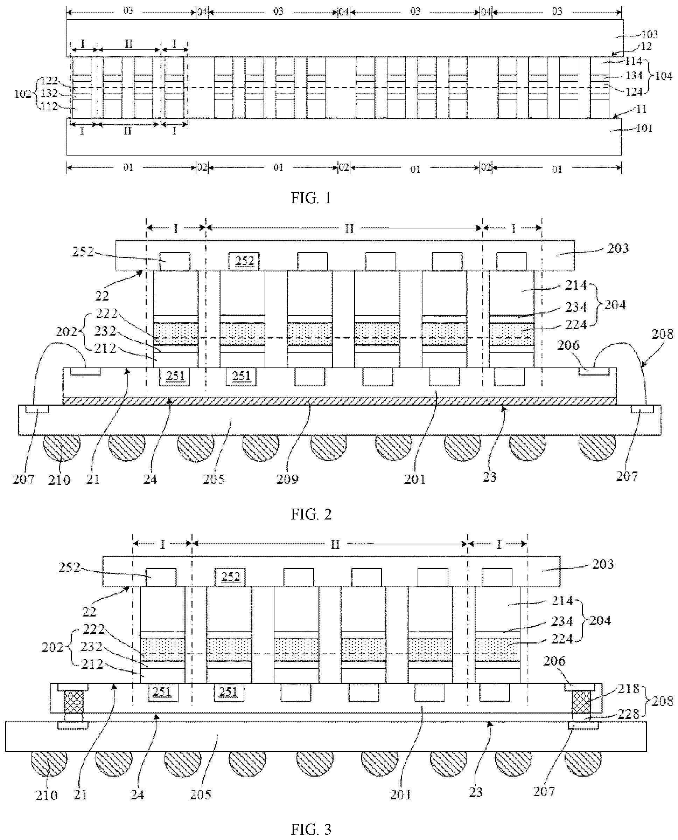

FIG. 1 is a schematic sectional view of a packaging structure provided in a first embodiment of the present disclosure.

With reference to FIG. 1, in the first embodiment, the packaging structure includes: a first semiconductor unit 101 and a second semiconductor unit 103. Herein, the first semiconductor unit 101 has a first surface 11, and at least one first conductive bump 102 is provided on the first surface 11. The second semiconductor unit 103 is fixed on the first surface 11. The second semiconductor unit 103 has a second surface 12, at least one second conductive bump 104 is provided on the second surface 12. The second surface 12 and the first surface 11 face to each other, and the second conductive bump 104 and the first conductive bump 102 are oppositely arranged and fixed to each other. The second semiconductor unit 103 and the first semiconductor unit 101 are electrically connected through the second conductive bump 104 and the first conductive bump 102.

In the following, the packaging structure provided in this embodiment is described in detail with reference to the drawings.

In this embodiment, the first semiconductor unit 101 is a first wafer, and the second semiconductor unit 103 is a second wafer.

The first semiconductor unit 101 may be a microcontroller unit (MCU) wafer, while the second semiconductor unit 103 may be a storage wafer. The second semiconductor unit 103 may be a read-only memory (ROM), a programmable read-only memory (PROM), an erasable programmable read-only memory (EPROM), an electrically-erasable programmable read-only memory (EEPROM), a flash read-only memory (FLASH ROM), a static random-access memory (SRAM) or a dynamic random-access memory (DRAM) and the like.

The first surface 11 may be a front surface of the first semiconductor unit 101. The second surface 12 may be a front surface of the second semiconductor unit 103.

In this embodiment, the first semiconductor unit 101 includes a plurality of first chips 01 and a plurality of first scribe line regions 02 each connecting two adjacent first chips 01. In a following step, cutting is performed along the first scribe line regions 02 so that the first chips 01 are separated from each other. The second semiconductor unit 103 includes a plurality of second chips 03 and a plurality of second scribe line regions 04 each connecting two adjacent second chips 03. In a following step, cutting is performed along the second scribe line regions 04 so that the second chips 03 are separated from each other. The first chips 01 may be master chips, the second chips 03 may be slave chips, and a control or operation instruction is delivered to the second chip 03 through the first chip 01. In order to reduce difficulty of a subsequent cutting process, each of the second scribe line regions 04 is right opposite a respective one of the first scribe line regions 02. In other embodiments, the second scribe line regions and the first scribe line regions may be arranged in a stagger manner.

Each chip 01 has a first conductive bump 102 provided thereon, and each second chip 03 has a second conductive bump 104 provided thereon. The first conductive bump 102 is taken as a communication input and output (I/O) interface of the first chip 01, and the second conductive bump 104 is taken as a communication input and output interface of the second chip 03. The first conductive bump 102 and the second conductive bump 104 electrically connect the first chip 01 to the second chip 03 and provide support between the first semiconductor unit 101 and the second semiconductor unit 103.

The contact of the first conductive bump 102 and the second conductive bump 104 may realize interconnection between a micro-processing control chip and a storage wafer. In such a packaging structure, parallel input and output interfaces may be employed to complete operations such as acquiring instructions, executing instructions, and exchanging information with an external memory and a logic component.

A top surface of the first conductive bump 102 fixedly contacts a top surface of the second conductive bump 104. In this embodiment, the first conductive bump 102 includes a first conductive pillar 112 and a first soldered bump 122 that are stacked in order on the first surface 11, and a top surface of the first soldered bump 122 forms the top surface of the first conductive bump 102. The second conductive bump 104 includes a second conductive pillar 114 and a second soldered bump 124 that are stacked in order on the second surface 12, and a top surface of the second soldered bump 124 forms the top surface of the second conductive bump 104. In this embodiment, in a forming process of the packaging structure, materials of the first soldered bump 122 and the second soldered bump 124 are fused with each other, so that the second soldered bump 124 and the first soldered bump 122 are integrated into one structure. In order to facilitate illustration and description, a boundary between the first soldered bump 122 and the second soldered bump 124 is shown by a dotted line in FIG. 1, which may be taken as a fixed contact between the top surface of the first conductive bump 102 and the top surface of the second conductive bump 104.

With stacking structures of the first conductive bump 102 and the second conductive bump 104, it is ensured that the first conductive bump 102 and the second conductive bump 104 have good conductivity in both electricity and heat, and meanwhile it is advantageous for strengthening the fixed contact of the top surface of the first conductive bump 102 and the top surface of the second conductive bump 104.

The first conductive bump 102 may further include a first conductive bonding layer 132 located between the first conductive pillar 112 and the first soldered bump 122. The first conductive bonding layer 132 improves bonding between the first conductive pillar 112 and the first soldered bump 122. The second conductive bump 104 may further include a second conductive bonding layer 134 located between the second conductive pillar 114 and the second soldered bump 124. The second conductive bonding layer 134 improves bonding between the second conductive pillar 114 and the second soldered bump 124.

The first conductive pillar 112 or the second conductive pillar 114 may be made from materials such as copper, tin, gold or silver. The first conductive bonding layer 132 or the second conductive bonding layer 134 may be made from materials such as nickel or nickel alloy. The first soldered bump 122 or the second soldered bump 124 may be made from materials such as tin-silver alloy. The first conductive pillar 112 and the second conductive pillar 114 have good conductivity in both electricity and heat, and the first soldered bump 122 and the second soldered bump 124 have good solderability.

In other embodiments, a first conductive bump or a second conductive bump may further be a single-layer structure or any other stacked structure. The single-layer structure may include, for example, a gold sphere or a tin sphere. The stacked structure may include, for example, a double-layer structure or a four-layer structure. That is, the number of layers of the first conductive bump may vary from that of the second conductive bump, and their material may vary.

The first conductive pillar 112 and the second conductive pillar 114 may be shaped as columns, for example, circle columns or square columns. The first soldered bump 122 and the second soldered bump 124 may be spheres or hemispheres.

In other embodiments, the first conductive bump and the second conductive bump may be made from other appropriate conductive materials, and may have other appropriate shapes, as long as the first conductive bump and the second conductive bump can fixedly contact and be electrically connected.

In order to prevent static electricity from damaging a chip so much that the chip fails to operate normally, and ensure stability of performance of the chip, each of the first semiconductor unit 101 and the second semiconductor unit 103 is provided with an electro-static discharge circuit (ESD) electrically connected to the communication input and output interface to avoid an instantaneous super charge in the first semiconductor unit 101 and the second semiconductor unit 103 caused by static electricity, so as to prevent the static electricity from damaging the chip. Specifically, the packaging structure has a first region I and a second region II, and a preset electro-static discharge voltage value in the first region I is greater than a preset electro-static discharge voltage value in the second region II.

The first semiconductor unit 101 may include a first region I and a second region II, and a first electro-static discharge circuit (not illustrated) electrically connected with the first conductive bump 102 is provided in the first semiconductor unit 101.A preset electro-static discharge voltage value of the first electro-static discharge circuit in the first region I is greater than a preset electro-static discharge voltage value of the first electro-static discharge circuit in the second region II. That is, the first electro-static discharge circuit in the first region I may resist a greater static electricity compared with the first electro-static discharge circuit in the second region II. The second semiconductor unit 103 may include a first region I and a second region II. The first region I of the first semiconductor unit 101 and the first region I of the second semiconductor unit 103 are opposite each other, and the second region II of the first semiconductor unit 101 and the second region II of the second semiconductor unit 103 are opposite each other. A second electro-static discharge circuit (not illustrated) electrically connected with the second conductive bump 104 is provided in the second semiconductor unit 103. A preset electro-static discharge voltage value of the second electro-static discharge circuit in the first region I is greater than a preset electro-static discharge voltage value of the second electro-static discharge circuit in the second region II. That is, the second electro-static discharge circuit in the first region I my resist a greater static electricity compared with the second electro-static discharge circuit in the second region II.

Specifically, each of the first region I and the second region II of the first chip 01 has a first electro-static discharge circuit electrically connected with the corresponding first conductive bump(s) 102. The first electro-static discharge region I and the electro-static discharge second region II of the second chip 03 respectively have a second electro-static discharge circuit electrically connected with the corresponding second conductive bump(s) 104.

A thickness of the first conductive pillar 112 in the first region I may be greater or smaller than or equal to a thickness of the first conductive pillar 112 in the second region II. A thickness of the second conductive pillar 114 in the first region I may be greater or smaller than or equal to a thickness of the second conductive pillar 114 in the second region II.

A material of the first conductive bump 102 in the first region I may be the same as or different from a material of the first conductive bump 102 in the second region II. A material of the second conductive bump 104 in the first region I may be the same as or different from a material of the second conductive bump 104 in the second region II.

Compared with existing technologies, in this embodiment, by connecting two wafers through flipping packaging, the electrical connection path therebetween is effectively shortened, impedance is lowered, thereby power consumption is effectively reduced while a signal transmission speed is increased, heat dissipation and electrical performance of the chip is improved. In addition, a size of the packaging structure may be effectively reduced compared with that using the wire bonding packaging method. The flipping here is simply described as that the front surfaces of the two wafers face to each other, so as to complete packaging.

In addition, by means of flipping packaging two wafers to form a packaging structure, the packaging structure formed therefrom can realize more functions than a single-piece wafer does.

For example, when the first semiconductor unit 101 is a micro-processing control wafer and the second semiconductor unit 103 is a storage wafer. The storage wafer and the micro-processing control wafer are flipped and packaged and interconnected through the first conductive bump 102 and the second conductive bump 104, and complete operations such as acquiring an instruction, executing the instruction, and exchanging information with an external memory or a logic component via the parallel input and output interfaces. It may be considered that the packaging structure can achieve embedded flash performance, thus the packaging structure may be used to replace the embedded flash wafer processing, which is advantageous for reducing cost, and may facilitate flexibility and standardization in chip design in regard to requirements on different storage capacities. If the embedded flash wafer process is used, cost for the wafer is high, and the embedded flash wafer processing is less standardized or less flexible in regard to requirements on different storage capacities.

A second embodiment of the present disclosure relates to a packaging structure, and is different from the first embodiment in that, in the second embodiment, the first semiconductor unit is a single chip, and the second semiconductor unit is a single chip.

FIG. 2 is a schematic sectional view of a packaging structure provided in a second embodiment of the present disclosure.

With reference to FIG. 2, in this embodiment, the packaging structure includes a first semiconductor unit 201 and a second semiconductor unit 203. Herein, the first semiconductor unit 201 has a first surface 21 and a fourth surface 24 opposite the first surface 21, and at least one first conductive bump 202 is provided on the first surface 21. The second semiconductor unit 203 has a second surface 22, and is fixed over the first surface 21, and at least one second conductive bump 204 is provided on the second surface 22. The second surface 22 is and the first surface 21 face to each other, and the second conductive bump 204 and the first conductive bump 202 are oppositely arranged and fixed to each other. The second semiconductor unit 203 and the first semiconductor unit 201 are electrically connected through the second conductive bump 204 and the first conductive bump 202.

In the following, the packaging structure provided in this embodiment is described in detail with reference to the drawings. Content identical or equivalent with the first embodiment may be seen in the first embodiment and is not repeated here.

In this embodiment, the first semiconductor unit 201 is a first chip, and the first surface 21 may be a front surface of the first chip; the second semiconductor unit 203 is a second chip, and the second surface 22 may be a front surface of the second chip. The first chip may be a micro-processing control chip, while the second chip may be a storage chip. That is, the first chip is a master chip, while the second chip is a slave chip. The first conductive bump 202 is taken as a communication input and output interface of the first semiconductor unit 201, and the second conductive bump 204 is taken as a communication input and output interface of the second semiconductor unit 203. The first conductive bump 202 and the second conductive bump 204 provide electrical connection and support between the first semiconductor unit 201 and the second semiconductor unit 203.

The first chip and the second chip are flipped and packaged, and a top surface of the first conductive bump 202 and a top surface of the second conductive bump 204 contact are electrically connected, which may realize interconnection between the micro-processing control chip and the storage chip, and complete operations such as acquiring an instruction, executing an instruction, and exchanging information with an external memory and logic component via the parallel input and output interfaces.

The top surface of the first conductive bump 202 fixedly contacts the top surface of the second conductive bump 204. In this embodiment, the first conductive bump 202 includes a first conductive pillar 212 and a first soldered bump 222 that are stacked in order on the first surface 21. The second conductive bump 204 includes a second conductive pillar 214 and a second soldered bump 224 that are stacked in order on the second surface 22.

The first conductive bump 202 may further include a first conductive bonding layer 232. The second conductive bump 204 may further include a second conductive bonding layer 234.

For materials and shapes of the first conductive bump 202 and the second conductive bump 204, description in the previous embodiment may be referred to.

The packaging structure may further include: a carrier 205. The carrier has a third surface 23. The first semiconductor unit 201 is fixed on the third surface 23 and electrically connected with the carrier 205. The fourth surface 24 faces the third surface 23.

The carrier 205 supports the first semiconductor unit 201, and electrically connects the first semiconductor unit 201 with an external circuit or external device. The carrier 205 may be a substrate, a frame, a printed circuit board (PCB) or a flexible printed circuit board (FPC).

The first semiconductor unit 201 accommodates at least one first soldered pad 206, and a surface of the first soldered pad 206 is exposed from the first surface 21. The carrier 205 accommodates at least one second soldered pad 207, and a surface of the second soldered pad 207 is exposed from the third surface 23. The packaging structure further includes: an electrically-connecting structure 208 electrically connecting the second soldered pad 207 with the first soldered pad 206.

As shown in FIG. 2, the electrically-connecting structure 208 may be a metal wire that is produced through wire bonding. The metal wire has one end fixedly connected with the second soldered pad 207 and the other end fixedly connected with the first soldered pad 206. The metal wire is made from a material such as metal or metal alloy, and the metal may be gold, silver, copper or platinum.

The packaging structure may further include an adhesive layer 209 located between the first semiconductor unit 201 and the carrier 205 and for adhering the first semiconductor unit 201 with the carrier 205. The adhesive layer 209 may be a die attach film (DAF) or epoxy. The adhesive layer 209 is made from a thermosetting material.

In other embodiments, the fourth surface and the third surface may contact each other, and a bonding processing like direct bonding may be used to fixedly adhere the first semiconductor unit to the third surface of the carrier.

FIG. 3 is a schematic sectional view of another packaging structure provided in the second embodiment of the present disclosure. As shown in FIG. 3, the electrically-connecting structure 208 includes: a through silicon via (TSV) 218 located within the first semiconductor unit 201 and having one end connected with the first soldered pad 206; and a third conductive bump 228 electrically connecting the through silicon via 218 and the second soldered pad 207. The third conductive bump 228 provides electrical connection and physically fixed connection between the first semiconductor unit 201 and the carrier 205.

The packaging structure may further include a fourth conductive bump 210 located on a back surface of the carrier 205, the back surface refers to a surface opposite the third surface 23. The fourth conductive bump 210 may be shaped as a pillar, a sphere or a hemisphere for realizing interconnection between internal circuits in the first semiconductor unit 201 and second semiconductor unit 203 and an external circuit or an external device, and facilitating a possible subsequent requirement of surface mount technology (SMT).

The packaging structure may further include a molding layer (not illustrated) configured to seal the first semiconductor unit 201, the second semiconductor unit 203 and the carrier 205, and protect the chip.

In this embodiment, the packaging structure has a first region I and a second region II. The first semiconductor unit 201 includes a first region I and a second region II. The second semiconductor unit 203 includes a first region I and a second region II. The first region I of the first semiconductor unit 201 is opposite the first region I of the second semiconductor unit 203, the second region II of the first semiconductor unit 201 is opposite the second region II of the second semiconductor unit 203. An electro-static discharge voltage value of the first region I is greater than an electro-static discharge voltage value of the second region II. For the first semiconductor unit 201, each of the first region I and the second region II has a first electro-static discharge circuit 251 electrically connected with the corresponding first conductive bump(s) 202 A preset electro-static discharge voltage value in the first electro-static discharge circuit 251 of the first region I is greater than a preset electro-static discharge voltage value in the first electro-static discharge circuit 251 of the second region II. For the second semiconductor unit 203, each of the first region I and the second region II has a second electro-static discharge circuit 252 electrically connected with the corresponding second conductive bump(s) 204. A preset electro-static discharge voltage value in the second electro-static discharge circuit 252 of the first region I is greater than a preset electro-static discharge voltage value in the second electro-static discharge circuit 252 of the second region II. It shall be noted that the first electro-static discharge circuit 251 and the second electro-static discharge circuit 252 in FIG. 2 and FIG. 3 are merely for illustration and description without defining an actual structure or shape.

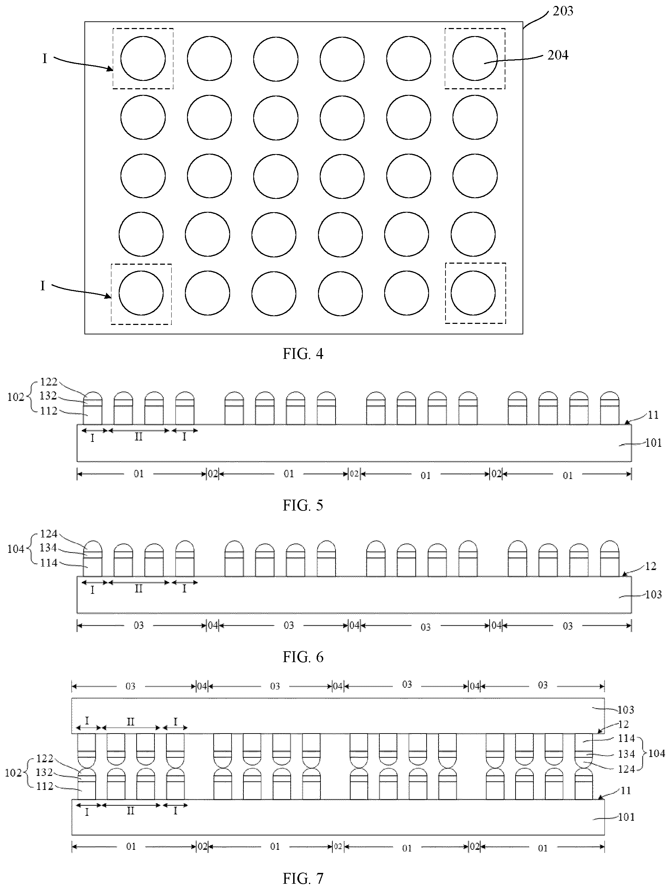

FIG. 4 is a schematic top view of a second semiconductor unit in the second embodiment. As shown in FIG. 4, that the second conductive bumps 204 are arranged in a rectangular array is taken as an example. The first region I may be located at four corners of the rectangular array. During packaging, second conductive bumps 204 of the first region I at these four places may discharge in advance static electricity instantaneously generated from an contact, which is advantageous for reducing dependence of the static electricity on the second electro-static discharge circuit 252, and for reducing space taken by the second electro-static discharge circuit 252 in the second semiconductor unit 203, thereby the size of the second semiconductor unit 203, i.e., the second chip, is reduced and cost therefor is reduced.

Positions of the first regions I and second regions II may be reasonably arranged according to an actual need. For example, the first regions I and second regions II may be arranged alternately. There may be one or any other number of first regions I.

In this embodiment, compared with existing technologies, the technology is introduced for the first time that conductive bumps of two chips are butt-soldered, i.e., the first conductive bumps of the first chip and the second conductive bump of the second chip are soldered to be fixed. In this way, transmission between the first chip and second chip is faster during operation, impedance thereof is lower, heat dissipation is faster and power consumption of the chips is lower. In this way, the purpose is achieved that input and output interfaces of the first chip and second chip in parallel complete instructions or operations, i.e., acquiring instructions, executing instructions, and exchanging information with an external memory and logic component.

In addition, the packaging structure may replace the embedded flash wafer processing, thereby manufacturing cost is reduced. Besides, in regard to requirements on different storage capacities, packaging design for such chips is more flexible and standardized, and thus such packaging design is more flexible and standardized.

In addition, with less space taken by the first electro-static discharge circuit in the second region II and reduced complexity thereof, the size of the first chip is reduced, parasitic effect resulted from the first electro-static discharge circuit is reduced, and electrical performance of the first chip is improved, and cost of the first chip is reduced. Similarly, the size of the second chip is reduced, electrical performance of the second chip is improved, and cost of the second chip is reduced.

In other embodiments, the first semiconductor unit may include a plurality of chips, while the second semiconductor unit may be one wafer. Alternatively, the first semiconductor unit may be one wafer, while the second semiconductor unit may include a plurality of chips.

Correspondingly, some embodiments of the present disclosure further relate to a forming method for a packaging structure, which is employed to form the above packaging structure. The forming method includes: providing a first semiconductor unit including a chip or a wafer, the first semiconductor unit having a first surface and a fourth surface opposite the first surface, and at least one first conductive bump being provided on the first surface; providing a second semiconductor unit including one chip or one wafer, the second semiconductor unit having a second surface, and at least one second conductive bump being provided on the second surface; and fixedly connecting a top surface of the second conductive bump with a top surface of the first conductive bump, the second surface being opposite the first surface. The forming method is used to form a packaging structure with excellent structural performance.

A third embodiment of the present disclosure relates to a forming method for a packaging structure. Herein, that the first semiconductor unit is one wafer and the second semiconductor unit is one wafer is taken as an example. FIGs. 5 to 8 are schematic views of structures corresponding to respective steps of the forming method for a packaging structure provided in the third embodiment of the present disclosure. In the following, detailed description is provided with reference to the drawings, and content identical or equivalent with the previous embodiment may be seen in the previous embodiment for details and is not repeated here.

With reference to FIG. 5, a first semiconductor unit 101 is provided. The first semiconductor unit 101 includes one wafer, and has a first surface 11on which at least one first conductive bump 102 is provided.

In this embodiment, the first semiconductor unit 101 is a first wafer including a plurality of chips 01 and a plurality of first scribe line regions 02. The first surface 01 may be a front surface of the first wafer.

In this embodiment, the first conductive bump 102 includes a first conductive pillar 112, a first conductive bonding layer 132 and a first soldered bump 122 that are stacked in order. A top surface of the first soldered bump 122 may be an arc surface.

A plurality of first conductive bumps 102 are provided, and may be formed through such processes as electroplating, pulsed laser deposition, sputtering or evaporation.

In this embodiment, the first semiconductor unit 101 may include a first region I and a second region II. An electro-static discharge voltage value of the first region I is greater than an electro-static discharge voltage value of the second region II. Each of the first region I and the second region II in the first semiconductor unit 101has a first electro-static discharge circuit connected with the first conductive bumps 102. A preset electro-static discharge voltage value in the first electro-static discharge circuit of the first region I is greater than a preset electro-static discharge voltage value in the first electro-static discharge circuit of the second region II. The first region I may be appropriately positioned as needed. For example, when the plurality of first conductive bumps 102 in each first chip of the first semiconductor unit 101 are arranged in a rectangular array, the first regions I may be positioned at four corners of the rectangular array. Correspondingly, each first chip has four first regions I, and each of the first regions I has at least one of the first conductive bumps 102.

In this embodiment, a maximum thickness of the first conductive bump 102 in the first region I is equal to a maximum thickness of the first conductive bump 102 in the second region II. In other embodiments, the maximum thickness of first conductive bump in the first region may further be greater than the maximum thickness of the first conductive bump in the second region. The maximum thickness refers to a thickness taken from a highest point of a top surface of the first conductive bumps 102 to a bottom surface of the first conductive bumps 102.

With reference to FIG. 6, a second semiconductor unit 103 is provided. The second semiconductor unit 103 includes one wafer, and has a second surface 12 on which at least one second conductive bump 104 is provided.

The second semiconductor unit 103 is a second wafer including a plurality of second chips 03 and a plurality of second scribe line regions 04. In this embodiment, the second semiconductor unit 103 includes a first region I and a second region II. Each of the first region I and the second region II in the second semiconductor unit 103 has a second electro-static discharge circuit connected with second conductive bumps 104. A preset electro-static discharge voltage value in the second electro-static discharge circuit of the first region I is greater than a preset electro-static discharge voltage value in the second electro-static discharge circuit of the second region II.

A second conductive bump 104 includes a second conductive pillar 114, a second conductive bonding layer 134 and a second soldered bump 124 stacked in order.

In this embodiment, the second semiconductor unit 103 includes a first region I and a second region II. During a subsequent flipping and fixing of the first semiconductor unit 101 and the second semiconductor unit 103, the first region I of the first semiconductor unit 101 is right opposite the first region I of the second semiconductor unit 103. A maximum thickness of the second conductive bump 104 in the first region I is greater than a maximum thickness of the second conductive bump 104 in the second region II. The maximum thickness refers to a thickness taken from a highest point of a top surface of the second conductive bump 104 to a bottom surface of second conductive bump 104.

With reference to FIG. 7 and FIG. 1, the top surface of the second conductive bump 104 and the top surface of the first conductive bump 102 are fixedly connected, and the second surface 12 and the first surface 11 face to each other.

During the fixing connection, the top surface of the first conductive bump 102 contacts the top surface of the second conductive bump 104 earlier in the first region I than in the second region II.

With reference to FIG. 7, the second semiconductor unit 103 is flipped and arranged over the first surface 11. The first conductive bump 102 corresponds to the second conductive bump 104 in position, and the top surface of the first conductive bump 102 contacts the top surface of the second conductive bump 104 in the first region I first.

When the top surface of the first conductive bump 102 contacts the top surface of the second conductive bump 104 in the first region I, the top surface of the first conductive bump 102 does not contact the top surface of the second conductive bump 104 in the second region I. An instantaneous static electricity discharge path may be formed instantaneously as the top surface of the first conductive bump 102 first contacts the top surface of the second conductive bump 104 in the first region I, that is, the contact instantaneously generates a discharge mode. The first electro-static discharge circuit and the second electro-static discharge circuit in the first region I may discharge static electricity generated instantaneously from an contact between the first semiconductor unit 101 and the second semiconductor unit 103, thereby preventing the static electricity generated instantaneously from the contact from damaging the first semiconductor unit 101 or the second semiconductor unit 103. In this way, a dependence of the first semiconductor unit 101 or the second semiconductor unit 103 on an electro-static discharge circuit may be reduced. By using such a packaging method, static electricity generated instantaneously from a contact may be discharged during packaging, which is advantageous for reducing dependence of a first chip on a first electro-static discharge circuit, and dependence of a second chip on a second electro-static discharge circuit.

For example, an electro-static discharge voltage value of the first region I is preset as 2KV, i.e., the first electro-static discharge circuit and the second electro-static discharge circuit in the first region I may resist a static electricity of 2KV. Therefore, when the first conductive bump 102 and the second conductive bump 104 in the first region I contact and thus instantaneously generate static electricity, the first electro-static discharge circuit and the second electro-static discharge circuit in the first region I protect the first semiconductor unit 101 and the second semiconductor unit 103 from being damaged by the static electricity. When the first conductive bump 102 and the second conductive bump 104 in the second region II are being butt-soldered, a conductive path has already been formed between the first semiconductor unit 101 and the second semiconductor unit 103 in the first region I , such that no more great static electricity will be generated instantaneously due to contact between first conductive bump 102 and the second conductive bump 104 in the second region II. Therefore, a smaller electro-static discharge voltage value is preset for the first electro-static discharge circuit and the second electro-static discharge circuit in the second region II, i.e., the first electro-static discharge circuit or the second electro-static discharge circuit in the second region II can resist smaller static electricity. An electro-static discharge voltage value of the second region II may be preset as smaller than 2KV, for example, it is sufficient as long as the first electro-static discharge circuit and the second electro-static discharge circuit in the second region II can resist a static electricity of 500v. Therefore, a structure of the first electro-static discharge circuit and the second electro-static discharge circuit in the second region II is simple, for example, a metal-oxide-semiconductor field-effect transistor (MOS) for the electro-static discharge circuit has a reduced size, and thus the corresponding chip has a reduced size, resulting in a reduced cost for the chip. In addition, due to the reduced size of the MOS, parasitic effect caused by the MOS is reduced, which is advantageous for improving performance of the chip.

It is known from the above analysis that because space taken by the first electro-static discharge circuit and the second electro-static discharge circuit in the second region II is reduced or complexity thereof is lowered, sizes of the first chip and second chip are reduced, and thereby cost therefor is reduced. In addition, the parasitic effect is reduced while a need for electro-static discharge is ensured, the first chip and the second chip have improved performance. This embodiment can solve a problem of designing the electro-static discharge circuit in a chip through improvement of the packaging method, thereby conflict between the need for electro-static discharge and reducing size and improving performance of a chip is resolved.

In order to ensure that the top surface of the first conductive bump 102 contacts the top surface of the second conductive bump 104 in the first region I first, before the fixing connection, a sum of a maximum thickness of the first conductive bump 101 and a maximum thickness of a corresponding second conductive bump 104 in the first region I is a first thickness, a sum of a maximum thickness of the first conductive bump 102 and a maximum thickness of a corresponding second conductive bump 104 in the second region II is a second thickness, and the first thickness is greater than the second thickness.

In this embodiment, the top surfaces of the first conductive bumps 102 in the first region I and the second region II are flush with each other. Concerning the top surface of the first conductive bump 102 being an arc surface, the maximum thickness of the first conductive bump 102 in the first region I is equal to the maximum thickness of the first conductive bump 102 in the second region II, and the maximum thickness of the second conductive bump 104 in the first region I is greater than the maximum thickness of the second conductive bump 104 in the second region II.

In other embodiments, before a fixing connection, the top surfaces of the second conductive bumps in the first region and the second region may also be flush with each other, and the maximum thickness of the first conductive bump in the first region is greater than the maximum thickness of the first conductive bump in the second region. Alternatively, other solutions on thickness may be arranged as long as it is ensured that the first conductive bump and the second conductive bump in the first region contact first.

With reference to FIG. 1, after the first conductive bump 102 contacts the second conductive bump 104 in the first region I, the top surface of the first conductive bump 102 and the top surface of the second conductive bump 104 are fixedly connected.

A first soldering process is performed on the first conductive bump 102 and the second conductive bump 104 in the first region I, and during the first soldering process, the top surface of the first conductive bump 102 contacts the top surface of the second conductive bump 104 in the second region II. Then, a second soldering process is performed so that the top surface of the first conductive bump 102 fixedly contacts the top surface of the second conductive bump 104 in the second region II.

An ultrasonic welding process or a reflow process may be used to fixedly connect the top surface of the first conductive bump 102 to the top surface of the second conductive bump 104. During the first soldering process and the second soldering process, the first soldered bump 122 and the second soldered bump 124 are fused into one structure.

Following processing steps further include: a cutting process is performed on the first semiconductor unit 101 and the second semiconductor unit 103 to separate adjacent first chips 01 and adjacent second chips 03.

Compared with existing technologies, in this embodiment, a method for flipping and butt-soldering two wafers is introduced for the first time, reducing the chip electrical connection path between the chips in the two wafers, resulting in faster transmission between the chips in the two wafers during working , lower impedance, lower power consumption and faster heat dissipation.

In addition, embedded flash performance may be achieved after the two wafers are flipped and butt-soldered, for example, one wafer is a micro-processing control chip while the other is a storage wafer, which is advantageous for saving manufacturing cost for an embedded flash wafer. In addition, in regard to requirements on different storage capacities, packaging design for such chips is more flexible and standardized, and such packaging design is more flexible and standardized.

In addition, through the special structural design for the first conductive bumps and second conductive bumps on two wafers, some of the first conductive bumps and some of the second conductive bumps may be taken as static electricity discharge paths during packaging that discharge in advance static electricity generated instantaneously during contact, thereby reducing dependence of the chips of the wafer on the electro-static discharge circuit. Consequently, a MOS for forming the electro-static discharge circuit in the second region II has a much smaller size, which is advantageous for reducing the size of the chip in the wafer, and cost for the chip is reduced. In addition, because the size of the MOS is reduced, the parasitic effect is reduced, thereby performance of the chip is improved.

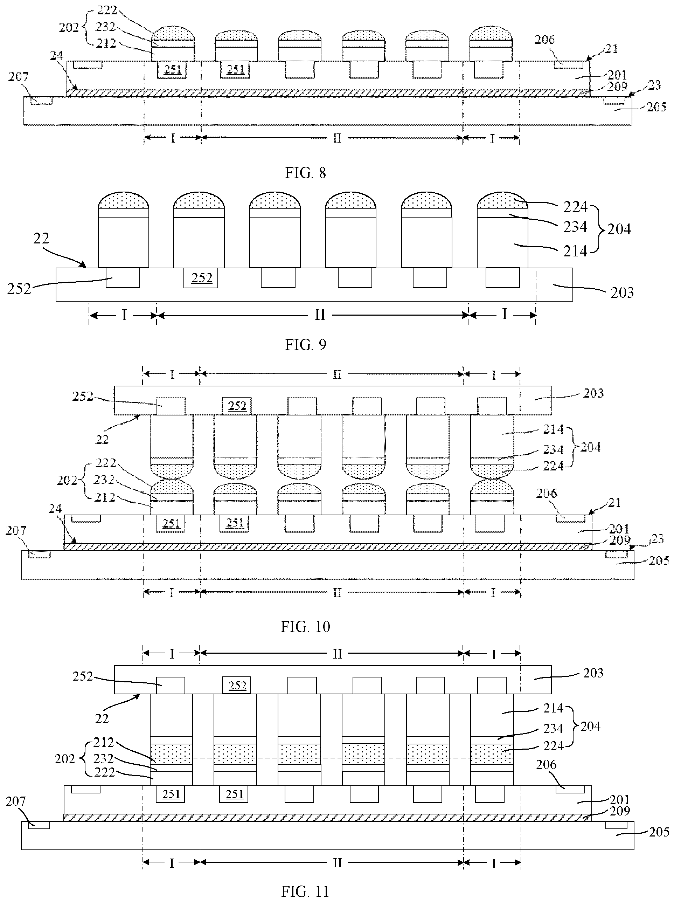

A fourth embodiment relates to a forming method for a packaging structure. The forming method is generally the same with that in the previous embodiment, but is different in that the first semiconductor unit is one chip and the second semiconductor unit is one chip. FIGs. 8 to 11 are schematic views of structures corresponding to respective steps of the forming method for the packaging structure provided in the fourth embodiment of the present disclosure.

With reference to FIG. 8, a first semiconductor unit 201 is provided. The first semiconductor unit 201 includes one chip, and has a first surface 21 and a fourth surface 24 opposite the first surface 21. At least one first conductive bump 202 is provided on the first surface 21.

In this embodiment, the first semiconductor unit 201 is a first chip. The first conductive bump 202 includes a first conductive pillar 212, a first conductive bonding layer 232 and a first soldered bump 222 stacked in order. A top surface of the first soldered bump 222 may be an arc surface.

A plurality of first conductive bumps 202 are provided, and may be formed through such processes as electroplating, pulsed laser deposition, sputtering or evaporation.

At least one first soldered pad 206 for electrically connecting a carrier provided later is provided in the first semiconductor unit 201.

In this embodiment, the first semiconductor unit 201 includes a first region I and a second region II. It is taken as an example that a maximum thickness of the first conductive bumps 202 in the first region I is greater than a maximum thickness of the first conductive bumps 202 in the second region II. Each of the first region I and the second region II in the first semiconductor unit 201 has a first electro-static discharge circuit 251 electrically connected with the first conductive bumps 202. A preset electro-static discharge voltage value in the first electro-static discharge circuit 251 of the first region I is greater than a preset electro-static discharge voltage value in the first electro-static discharge circuit 251 of the second region II.

With further reference to FIG. 8, a carrier 205 having a third surface 23 is provided. The fourth surface 24 of the first semiconductor unit 201 is fixed to the third surface 23.

The carrier 205 may be a substrate, a printed circuit board, a frame or a flexible printed circuit board.

In this embodiment, an adhesive layer 209 is used to fix the first semiconductor unit 201 to the carrier 205. In other embodiments, a fourth surface and a third surface may directly contact each other through the bonding process. Alternatively, the first semiconductor unit and the carrier may be fixed through an electrically-connecting structure, and the electrically-connecting structure may also electrically connect the first semiconductor unit and the carrier.

The carrier 205 accommodates at least one second soldered pad 207 for electrically connecting with the first soldered pad 206 to facilitate electrical connection between the first semiconductor unit 201 and an external circuit or an external device.

With reference to FIG. 9, a second semiconductor unit 203 having a second surface 22 is provided. The second semiconductor unit 203 is one chip, and at least one second conductive bump 204 is provided on the second surface 22.

The second semiconductor unit 203 is a second chip. The second conductive bump 204 includes a second conductive pillar 214, a second conductive bonding layer 234 and a second soldered bump 224 stacked in order.

In this embodiment, the second semiconductor unit 203 includes a first region I and a second region II. It is taken as an example that the top surface of the second conductive bumps 204 in the first region I and the second region II are flush with each other. Each of the first region I and the second region II has a second electro-static discharge circuit 252 electrically connected with the second conductive bumps 204, and a preset electro-static discharge voltage value in the second electro-static discharge circuit 252 of the first region I is greater than a preset electro-static discharge voltage value in the second electro-static discharge circuit 252 of the second region II.

With reference to FIG. 10 and FIG. 11, the top surface of the second conductive bump 204 and the top surface of the first conductive bump 202 are fixedly connected, and the second surface 22 and the first surface 21 face to each other. During the fixing connection, the top surface of the first conductive bump 202 contacts the top surface of the second conductive bump 204 earlier in the first region I than in the second region II. Specifically, the following steps are included.

With reference to FIG. 10, the second semiconductor unit 203 is flipped and arranged over the first surface 21. The first conductive bump 202 corresponds to the second conductive bump 204 in position, and the top surface of the first conductive bump 202 contacts the top surface of the second conductive bump 204 in the first region I earlier than in the second region II.

Because the top surface of the first conductive bump 202 contacts the top surface of the second conductive bump 204 in the first region I earlier, an instantaneous static electricity discharge path may be formed, that is, the contact instantaneously generates a discharge mode. The first electro-static discharge circuit 251 and the second electro-static discharge circuit 252 in the first region I discharge static electricity generated instantaneously from the contact, preventing the static electricity from damaging the first semiconductor unit 201 or the second semiconductor unit 203. In this way, a dependence of the first semiconductor unit 201 or the second semiconductor unit 203 on the electro-static discharge circuit may be reduced.

Therefore, in this embodiment, a smaller electro-static discharge voltage value is preset for the first electro-static discharge circuit 251 and the second electro-static discharge circuit 252 in the second region II, and correspondingly a size of the MOS is small, which is advantageous for reducing sizes of the first chip and the second chip, improving performances of the first chip and the second chip, and reducing cost therefor. In addition, because the size of the MOS is reduced, parasitic effect caused by the MOS is reduced, which is advantageous for improving performance of the chip. For details, the previous embodiment may be referred to and is not repeated.

With reference to FIG. 11, after the first conductive bump 202 contacts the second conductive bump 204 in the first region I, the top surface of the first conductive bump 202 and the top surface of the second conductive bump 204 are fixedly connected.

An ultrasonic soldering processing or a reflow soldering processing may be used to fixedly connect the top surface of the first conductive bump 202 and the top surface of the second conductive bump 204.

With reference to FIG. 2, following processing steps further include: a plastic-sealed layer is formed for sealing the first semiconductor unit 201, the second semiconductor unit 203 and the carrier 205; an electrically-connecting structure 208 electrically connecting the first soldered pad 206 and the second soldered pad 207 is formed, and the electrically-connecting structure 208 may be a metal wire; and at least one fourth conductive bump 210 is formed on a back surface of the carrier 205.

The forming method for the packaging structure provided in this embodiment is used for packaging two chips. Such flipping and butt-soldering process enables transmission between the chips to be faster, have lower impedance, lower power consumption and faster heat dissipation.

In addition, based on improvement on the packaging method for resolving the conflict between the need for electro-static discharge and reducing size and improving performance of a chip, such a new packaging method that may improve electro-static discharge performance and chip performance is provided. During packaging, it is designed that some of the first conductive bumps and some of the second conductive bumps contact in advance, so that a discharge mode is generated instantaneously from the contact and static electricity may be discharged in advance, thereby reducing dependence of the chip on the electro-static discharge circuit.

In other embodiments, the above forming method for a packaging structure may further be used for packaging of a chip and a wafer.

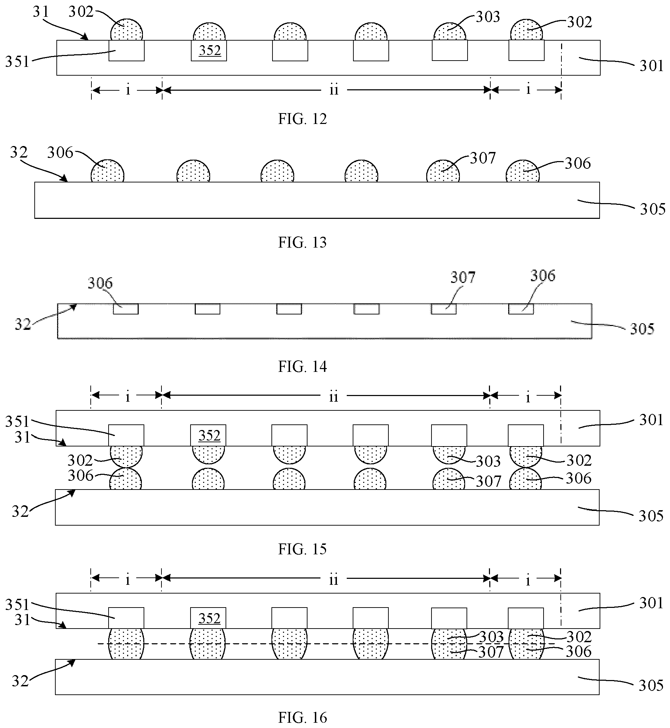

A fifth embodiment of the present disclosure relates to a packaging method. FIGs. 12 to 16 are schematic views of sectional structures corresponding to respective steps of the packaging method provided in the fifth embodiment of the present disclosure.

With reference to FIG. 12, a semiconductor unit 301 is provided. The semiconductor unit 301 includes a first region i and a second region ii, and an electro-static discharge voltage value in the first region i is greater than an electro-static discharge voltage value in the second region ii.

The semiconductor unit 301 includes a chip or a wafer. The semiconductor unit 301 has a first surface 31, a first conductive bump 302 is provided on a first surface 31 in the first region i, and a second conductive bump 303 is provided on a first surface 31 in the second region ii.

In this embodiment, it is taken as an example that each of the first conductive bump 302 and the second conductive bump 303 are both hemispheres, and both the first conductive bump 302 and the second conductive bump 303 are of single-layer structure. In other embodiments, for the shapes and structures of the first conductive bump and the second conductive bump, the previous embodiments may be referred to.

A first electro-static discharge circuit 351 connected with the first conductive bump 302 is provided in the first region i, and a second electro-static discharge circuit 352 connected with the second conductive bump 303 is provided in the second region ii. An electro-static discharge voltage value preset for the first electro-static discharge circuit 351 is greater than an electro-static discharge voltage value preset for the second electro-static discharge circuit 352.

In a subsequent packaging procedure, the first conductive bump 302 in the first region i may be taken as a path for discharging static electricity in advance so that static electricity generated instantaneously from a contact is discharged in advance. Therefore, the electro-static discharge voltage value preset for the second electro-static discharge circuit 352 in the second region ii may be preset as smaller, i.e., the second electro-static discharge circuit 352 in the second region ii can resist smaller static electricity, which is advantageous for reducing space arranged for the second electro-static discharge circuit 352 or complexity thereof, and thus is advantageous for reducing the size of the first semiconductor unit 301 and reducing the parasitic effect resulted from the electro-static discharge circuit in the first semiconductor unit 301. The size of the MOS for configuring the second electro-static discharge circuit 352 is reduced, which is advantageous for reducing the size of the first semiconductor unit 301 and the cost therefor. In addition, because the size of the MOS is reduced, the parasitic effect resulted from the MOS is reduced, and thus performance of the first semiconductor unit 301 is improved.

It is taken as an example that the first conductive bump 302 and the second conductive bump 303 are arranged in a rectangular array on the first surface 31. The first region i may be located at four corners of the rectangular array, and each electro-static region i has at least one first conductive bump 302. In others embodiment, the first region and the first region may be arranged alternately.

In this embodiment, when the first surface 31 is placed to face upwards, a top surface of the first conductive bump 302 is higher than a top surface of the second conductive bump 303. In other embodiments, a top surface of a first conductive bump may be lower than or may be flush with a top surface of a second conductive bump.

With reference to FIG. 13, a carrier 305 is provided. The carrier 305 has a second surface 32, and a first connector 306 and a second connector 307 are provided on the second surface 32.

The carrier 305 may be a substrate, a frame, a printed circuit board or a flexible printed circuit board for electrically connecting the first semiconductor unit 301 with an external circuit or an external device. The first connector 306 is configured to electrically connect with the first conductive bump 302, and the second connector 307 is configured to electrically connect with the second conductive bump 303.

In this embodiment, the first connector 306 is of solder first bump structure, and the second connector 307 is of solder second bump structure. It is taken as an example that the first connector 306 and the second connector 307 are both hemispheres, and the first connector 306 and the second connector 307 are both of single-layer structure.

In this embodiment, a maximum thickness of the first connector 306 is equal to a maximum thickness of the second connector 307. In other embodiments, a maximum thickness of a first connector may be greater than a maximum thickness of a second connector.

In another embodiment, as shown in FIG. 14, the first connector 306 or the second connector 307 may be of pad structure, and a top surface of the first connector 306 and a top surface of the second connector 307 may be flush with or higher than the third surface 32. It may be appreciated that either of the first connector and the second connector may be of bump structure while the other is of pad structure.

With reference to FIG. 15 and FIG. 16, a flipping and fixing process is performed so that the top surface of the first conductive bump 302 and the top surface of the first connector 306 are fixedly connected, and the top surface of the second conductive bump 303 and the top surface of the second connector 307 are fixedly connected.

During the flipping and fixing process, the top surface of the first conductive bump 302 contacts the top surface of the first connector 306 earlier than the contact between the top surface of the second conductive bump 303 and the top surface of the second connector 307. The flipping and fixing process specifically include the following steps.

With reference to FIG. 15, the first semiconductor unit 301 is flipped and arranged over the second surface 32 of the carrier 305, and the top surface of the first conductive bump 302 contacts the top surface of the first connector 306 in the first region i.

When the top surface of the first conductive bump 302 is contacting the top surface of the first connector 306, the top surface of the second conductive bump 303 does not contact the top surface of the second connector 307. The first conductive bump 302 and the first connector 306 contact to instantaneously form an electro-static discharge path, and the first electro-static discharge circuit 351 protects the first semiconductor unit 301 from being damaged by the static electricity generated instantaneously from the contact. When the second conductive bump 303 and the second connector 307 are being butt-soldered, a conductive path has already been formed between the first conductive bump 302 and first connector 306, such that no more great static electricity will be generated instantaneously due to the contact between the semiconductor unit 301 and the carrier 305. Therefore, dependence of the semiconductor unit 301 on the second electro-static discharge circuit 352 is reduced, a smaller electro-static discharge voltage value is preset for the second electro-static discharge circuit 352, i.e., the second electro-static discharge circuit 352 can resist smaller static electricity, thereby space arranged for the second electro-static discharge circuit 352 and complexity thereof are reduced. A MOS for the second electro-static discharge circuit 352 has a reduced size, and thus the chip has a reduced size and costs less. In addition, because the size of the MOS is reduced, the parasitic effect resulted from the MOS is reduced, which is advantageous for improving performance of the chip.

It is appreciated that before the flipping and fixing step, there may be a plurality of solutions on thicknesses of the first conductive bump 302, second conductive bump 303, first connector 306 and second connector 307, as long as it is ensured that the top surface of the first conductive bump 302 contacts the top surface of the first connector 306 first.

Before the fixing connection, a sum of a maximum thickness of the first conductive bump 302 and a maximum thickness of the first connector 306 is a first thickness, a sum of a maximum thickness of the second conductive bump 303 and a maximum thickness of the second connector 307 is a second thickness, and the first thickness is greater than the second thickness.

With reference to FIG. 16, the solder process is perform on the first conductive bump 302, the second conductive bump 303, the first connector 306 and the second connector 307, so that the first conductive bump 302 fixedly contacts the first connector 306, and the second conductive bump 303 fixedly contacts the second connector 307.

The first conductive bump 302 and the first connector 306 are integrated into one structure, and the second conductive bump 303 and the second connector 307 are integrated into one structure. In order to facilitate illustration and description, a boundary between the first conductive bump 302 and the first connector 306 and a boundary between the second conductive bump 303 and the second connector 307 are shown by a dotted line.

Compared with existing technologies, in this embodiment, during the procedure of flipping and arranging the semiconductor unit 301 over the carrier 305, the first conductive bump 302 contacts the first connector 306 in advance. Therefore, static electricity generated instantaneously from the contact may be discharged through the first conductive bump 302 and the first connector 306, thereby dependence of the semiconductor unit 301 on the electro-static discharge circuit is reduced. Therefore, the size of the MOS for forming the second electro-static discharge circuit 352 is reduced, thereby the size of the semiconductor unit 301 is reduced. In this way, the parasitic effect caused by complexity of the electro-static discharge circuit is reduced, and thereby electrical performance of the semiconductor unit 301 is improved. It may be appreciated that all models of electro-static discharge mentioned above may be a human body model (HBM).

Those skilled in the art may appreciate that the above embodiments are specific embodiments for realizing the present application. In practice, however, the embodiments may be varied in terms of form and details without departing from the principle and scope of the present disclosure.

## Claims

1. A packaging structure, comprising:
a first semiconductor unit comprising a wafer or a chip, the first semiconductor unit having a first surface on which at least one first conductive bump is provided; and
a second semiconductor unit fixed over the first surface and comprising a wafer or a chip, the second semiconductor unit having a second surface on which at least one second conductive bump is provided, the second surface and the first surface facing to each other, the second conductive bump and the first conductive bump being oppositely arranged and fixed to each other, and the second semiconductor unit and the first semiconductor unit being electrically connected through the second conductive bump and the first conductive bump.

2. The packaging structure according to claim 1, wherein the first conductive bump comprises a first conductive pillar and a first soldered bump that are stacked in order, the second conductive bump comprises a second conductive pillar and a second soldered bump that are stacked in order, and the second soldered bump and the first soldered bump are integrated into one structure.

3. The packaging structure according to claim 2, wherein the first conductive bump further comprises a first conductive bonding layer located between the first conductive pillar and the first soldered bump, and the second conductive bump further comprises a second conductive bonding layer located between the second conductive pillar and the second soldered bump.

4. The packaging structure according to claim 1, wherein the first semiconductor unit comprises a first region and a second region, the first semiconductor unit accommodates a first electro-static discharge circuit electrically connected with the first conductive bump, and a preset electro-static discharge voltage value of the first electro-static discharge circuit in the first region is greater than a preset electro-static discharge voltage value of the first electro-static discharge circuit in the second region.

5. The packaging structure according to claim 1, further comprising a carrier, wherein the carrier has a third surface on which the first semiconductor unit is fixed, and the first semiconductor unit is electrically connected with the carrier.

6. The packaging structure according to claim 5, wherein the first semiconductor unit accommodates at least one first soldered pad, a surface of the first soldered pad is exposed from the first surface, the carrier accommodates at least one second soldered pad, a surface of the second soldered pad is exposed from the third surface, and the packaging structure further comprises an electrically-connecting structure electrically connecting the second soldered pad and the first soldered pad.

7. The packaging structure according to claim 6, wherein the electrically-connecting structure is a metal wire having one end electrically connected with the first soldered pad and one other end electrically connected with the second soldered pad.

8. The packaging structure according to claim 7, further comprising an adhesive layer located between the first semiconductor unit and the carrier and configured to fix the first semiconductor unit to the carrier.

9. The packaging structure according to claim 6, wherein the electrically-connecting structure comprises a through silicon via located within the first semiconductor unit and having one end connected with the first soldered pad, and a third conductive bump electrically connecting the through silicon via and the second soldered pad.

10. The packaging structure according to claim 1, wherein the first semiconductor unit is a micro-processing control chip or a micro-processing control wafer, and the second semiconductor unit is a storage chip or a storage wafer.

11. A forming method for a packaging structure, comprising:
providing a first semiconductor unit, wherein the first semiconductor unit comprises a chip or a wafer, the first semiconductor unit has a first surface on which at least one first conductive bump is provided;
providing a second semiconductor unit, wherein the second semiconductor unit comprises a chip or a wafer, the second semiconductor unit has a second surface on which at least one second conductive bump is provided; and
connecting fixedly a top surface of the second conductive bump to a top surface of the first conductive bump, wherein the second surface and the first surface face to each other.

12. The forming method according to claim 11, wherein the first semiconductor unit comprises a first region and a second region, the first semiconductor unit accommodates a first electro-static discharge circuit electrically connected with the first conductive bump, and a preset electro-static discharge voltage value of the first electro-static discharge circuit in the first region is greater than a preset electro-static discharge voltage value of the first electro-static discharge circuit in the second region; and
during the connecting fixedly a top surface of the second conductive bump to a top surface of the first conductive bump, a contact between the top surface of the first conductive bump and the top surface of the second conductive bump in the first region occurs earlier than a contact between the top surface of the first conductive bump and the top surface of the second conductive bump in the second region.

13. The forming method according to claim 12, wherein before fixedly connecting the second conductive bump to the first conductive bump, a sum of a maximum thickness of the first conductive bump and a maximum thickness of a corresponding second conductive bump in the first region is a first thickness, a sum of a maximum thickness of the first conductive bump and a maximum thickness of a corresponding second conductive bump in the second region is a second thickness, and the first thickness is greater than the second thickness.

14. The forming method according to claim 11, wherein the top surface of the second conductive bump and the top surface of the first conductive bump are connected fixedly using an ultrasonic soldering processing or a reflow soldering processing.

15. The forming method according to claim 11, before the connecting fixedly a top surface of the second conductive bump to a top surface of the first conductive bump, further comprising: providing a carrier having a third surface on which the first semiconductor unit is fixed.

16. A packaging method, comprising:
providing a semiconductor unit having a first surface, wherein the semiconductor unit comprises a chip or a wafer, the semiconductor unit comprises a first region and a second region, a first conductive bump is provided on the first surface in the first region, a second conductive bump is provided on the first surface in the second region, the first region has a first electro-static discharge circuit connected with the first conductive bump, the second region has a second electro-static discharge circuit connected with the second conductive bump, and a preset electro-static discharge voltage value in the first electro-static discharge circuit is greater than a preset electro-static discharge voltage value in the second electro-static discharge circuit;
providing a carrier having a second surface, wherein a first connector and a second connector are provided on the second surface; and
performing a flipping and fixing process to fixedly connect a top surface of the first conductive bump to a top surface of the first connector, and to fixedly connect a top surface of the second conductive bump to a top surface of the second connector, wherein during the flipping and fixing process, a contact between the top surface of the first conductive bump and the top surface of the first connector occurs earlier than a contact between the top surface of the second conductive bump and the top surface of the second connector.

17. The packaging method according to claim 16, wherein the first connector is of first solder ball structure, and the second connector is of second solder ball structure.

18. The packaging method according to claim 17, wherein before the flipping and fixing process, a sum of a maximum thickness of the first conductive bump and a maximum thickness of the first connector is a first thickness, a sum of a maximum thickness of the second conductive bump and a maximum thickness of the second connector is a second thickness, and the first thickness is greater than the second thickness.

19. The packaging method according to claim 16, wherein the first connector or the second connector is of soldered pad structure.

20. The packaging method according to claim 16, wherein the carrier is a substrate, a frame, a printed circuit board or a flexible printed circuit board.
